# EUROPEAN PATENT APPLICATION

(11) **EP 2 677 554 A1**
(43) Date of publication of application: **25.12.2013**
(21) Application number: 12007047.9
(22) Date of filing: 11.10.2012
(51) Int. Cl.: H01L 31/05, H01L 31/068

(54) **Solar cell module and ribbon assembly applied to the same**

(30) Priority: 22.06.2012 KR 20120067536
(71) Applicant: LG ELECTRONICS INC., Yeongdeungpo-gu Seoul 150-721 (KR)
(72) Inventor: Moon, Kangseok, 137-724 Seoul (KR); Choi, Junghoon, 137-724 Seoul (KR)
(74) Representative: Katérle, Axel

(57) **Abstract**

A solar cell module (100) includes a plurality of solar cells (150)comprising a first solar cell (151) and a second solar cell (152); a ribbon (142) electrically connecting the first solar cell (151) and the second solar cell (152); and an insulating member (144) positioned between the plurality of solar cells (151, 152)and the ribbon (142). The insulating member is transparent and can be made from resin material such as polyethyleneterephthalate (PET), ethylene vinyl acetate (EVA), or silicon resin or a ceramic material such as silicon oxide, or silicon nitride. The ribbon (142) comprises at least one protrusion and depression (P) to achieve total reflection of light incident to the ribbon (142).

## Description

### CROSS-REFERENCE TO RELATED APPLICATION

This application claims priority to and the benefit of Korean Patent Application No. 10-2012-0067536, filed on June 22, 2012 in the Korean Intellectual Property Office, the disclosure of which is incorporated herein by reference.

### BACKGROUND OF THE INVENTION

### 1. Field of the invention

Embodiments of the present invention relate to a solar cell module and a ribbon assembly applied to the same.

### 2. Description of the Related Art

Recently, as existing energy resources such as oil or coal are expected to be exhausted, an interest in alternative energy resources for replacing oil or coal is increasing. In particular, a solar cell that directly converts or transforms solar energy into electricity using a semiconductor member is gaining attention.

A plurality of solar cells are connected to each other by ribbons and the plurality of solar cells are packaged for protection, to thereby manufacture a solar cell module. When the plurality of solar cells are connected by the ribbons, insulation films are used for preventing unwanted short-circuit. In this instance, the insulating film is opaque in order to increase an aesthetic property.

Then, the light incident to a portion where the opaque insulating film is positioned is not used for photoelectric conversion, so that an amount of the used light decreases and the efficiency of the solar cell decreases.

### SUMMARY OF THE INVENTION

One or more embodiments of the invention are directed to providing a solar cell module that is able to increase an amount of light that is used and to enhance efficiency, and a ribbon assembly applied to the solar cell module.

A solar cell module includes a plurality of solar cells comprising a first solar cell and a second solar cell; a ribbon electrically connecting the first solar cell and the second solar cell;, and an insulating member positioned between the plurality of solar cells and the ribbon. The insulating member is transparent.

A ribbon assembly according to an embodiment of the invention includes a ribbon electrically connecting a plurality of solar cells and an insulating member positioned at one surface of the ribbon. The ribbon includes at least one protrusion and depression having an inclined surface on at the one surface of the ribbon, and the insulating member being transparent.

### BRIEF DESCRIPTION OF THE DRAWINGS

FIG. 1 is a rear perspective view of a solar cell module according to an embodiment of the invention.

FIG. 2 is a partial cross-sectional view of one solar cell of the solar cell module shown in FIG. 1.

FIG. 3 is a rear plan view of the solar cell shown in FIG. 2.

FIG. 4 is a rear plan view for illustrating a connection structure between two solar cells of the solar cell module shown in FIG. 1.

FIG. 5 is a rear perspective view of ribbons according to various embodiments of the invention.

FIG. 6 is a partial cross-sectional view of the solar cell module shown in FIG. 4, taken along a line of VI-VI.

FIG. 7 shows cross-sectional views of ribbon assemblies applied to a solar cell module according to embodiments of the invention.

FIG. 8 is a rear plan view for illustrating a connection structure between two solar cells of a solar cell module according to another embodiment of the invention.

FIG. 9 is a rear plan view for illustrating a connection structure between two solar cells of a solar cell module according to still another embodiment of the invention.

FIG. 10 is a rear plan view for illustrating a connection structure between two solar cells of a solar cell module according to yet another embodiment of the invention.

FIG. 11 is a rear plan view for illustrating a connection structure between two solar cells of a solar cell module according to yet another embodiment of the invention.

FIG. 12 is a rear plan view for illustrating a connection structure between two solar cells of a solar cell module according to yet another embodiment of the invention.

FIG. 13 is a rear plan view for illustrating a connection structure between two solar cells of a solar cell module according to yet another embodiment of the invention.

FIG. 14 is a rear partial plan view for schematically illustrating a connection structure between two solar cells of a solar cell module according to yet another embodiment of the invention.

FIG. 15 is a rear partial plan view for schematically illustrating a connection structure between two solar cells of a solar cell module according to modified embodiment of FIG. 14.

FIG. 16 is a rear partial plan view for illustrating a connection structure between two solar cells of a solar cell module according to yet another embodiment of the invention.

FIG. 17 is a cross-sectional view of a solar cell module according to another embodiment of the invention.

FIG. 18 is a cross-sectional view of a solar cell module according to still another embodiment of the invention.

### DETAILED DESCRIPTION OF THE EMBODIMENTS

Hereinafter, embodiments of the invention will be described with reference to the accompanying drawings. However, the embodiments of the invention are not limited the embodiments, and the various modifications of the embodiments are possible.

In order to clearly and concisely illustrate the embodiments of the invention, members not related to the invention are omitted in the figures. Also, members similar to or the same as each other have the same reference numerals in the figures. In addition, dimensions of layers and regions are exaggerated or schematically illustrated, or some layers are omitted for clarity of illustration. In addition, the dimension of each part as drawn may not reflect an actual size.

In the following description, when a layer or substrate "includes" another layer or portion, it can be understood that the layer or substrate can further include still another layer or portion. Also, when a layer or film is referred to as being "on" another layer or substrate, it can be understood that the layer of film is directly on the other layer or substrate, or intervening layers may also be present. Further, when a layer or film is referred to as being "directly on" another layer or substrate, it can be understood that the layer or film is directly on the another layer or substrate, and thus, there is no intervening layer.

Hereinafter, a solar cell module according to embodiments of the invention will be described with reference to the accompanying drawings.

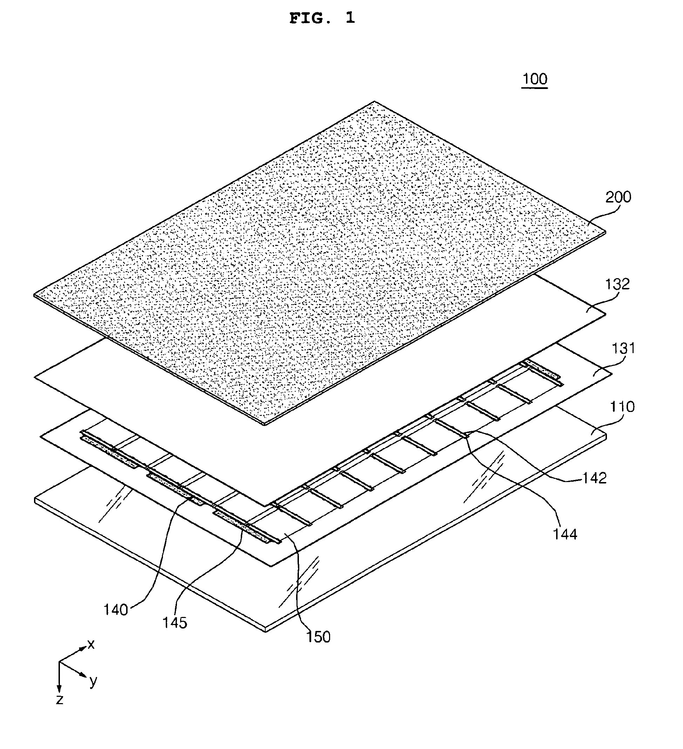

FIG. 1 is a rear perspective view of a solar cell module according to an embodiment of the invention. Referring to FIG. 1, a solar cell module 100 according to an embodiment of the invention includes a solar cell 150, a front substrate 110 positioned on a front surface of the solar cell 150, and a back sheet 200 on a back surface of the solar cell 150. Also, the solar cell module 100 may include a first sealing agent 131 disposed between the solar cell 150 and the front substrate 110, and a second sealing agent 132 disposed between the solar cell 150 and the back sheet 200.

First, each of the solar cells 150 is a device for converting solar energy into electric energy. Each of the solar cells 150, for example, may be a silicon solar cell. However, embodiments of the invention are not limited thereto and the solar cells 150 may be compound semiconductor solar cells, tandem solar cells, or dye-sensitized solar cells in other embodiments of the invention.

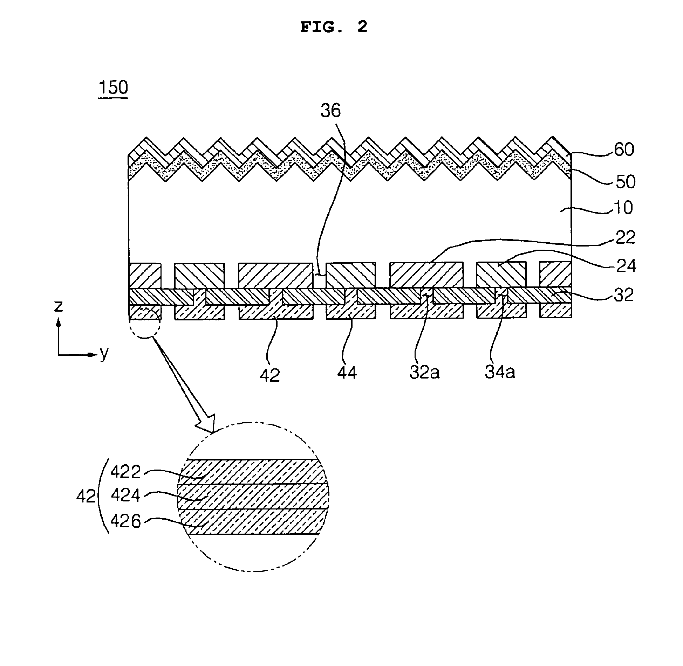

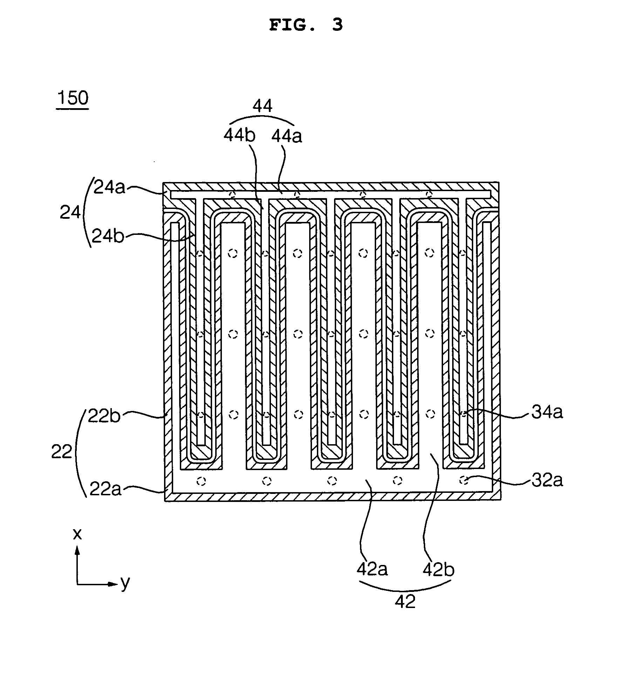

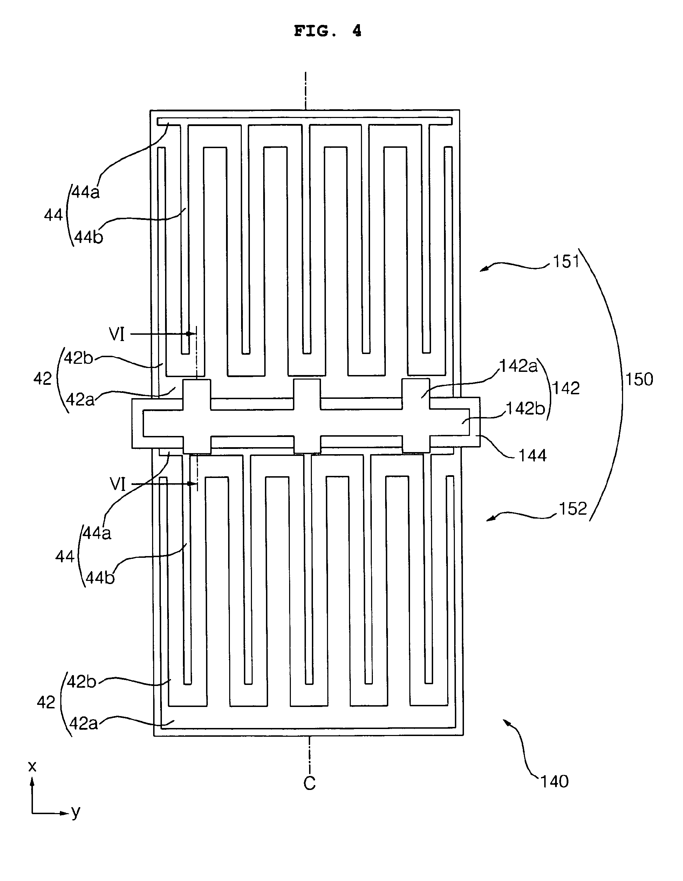

For example, in the embodiment of the invention, a silicon solar cell including first and second conductive regions (reference numerals 22 and 24 of FIG. 2), which have different conductive types, formed at a back surface of a semiconductor substrate (reference numeral 10 of FIG. 2) is used for the solar cell 150. This will be described in more detail with reference to FIG. 2 and FIG. 3. The solar cells 150 are electrically connected to each other in series, parallel, or series-and-parallel arrangement by a ribbon or ribbons 142 to form a solar cell string 140. This structure will be described in more detail with reference to FIG. 4.

In addition, each of bus ribbons 145 connect both or adjacent ends of the ribbons of the strings 140 alternately to electrically connect the strings 140 of the solar cells. The bus ribbons 145 may be arranged at ends of the solar cell strings 140 in a direction crossing a longitudinal direction of the solar cell string 140. In addition, the bus ribbons 145 collect electricity produced by the solar cells 150 and are connected to a junction box for preventing electricity from flowing backward or in a reverse direction.

The first sealing agent 131 may be positioned on light-receiving surfaces of the solar cells 150, and the second sealing agent 132 may be positioned on non-light-receiving surfaces of the solar cells 150. The first sealing agent 131 and the second sealing agent 132 are adhered to each other and/or to the solar cells 150 by lamination. The first sealing agent 131 and the second sealing agent 132 block moisture and/or oxygen that would adversely affect the solar cells 150, and chemically combine respective members of the solar cells 150.

The first sealing agent 131 and the second sealing agent 132 may include ethylene-vinyl acetate copolymer resin (EVA), polyvinyl butyral, silicon resin, ester-based resin, or olefin-based resin.

However, the embodiments of the invention are not limited thereto. Therefore, the first and second sealing agents 131 and 132 may include one or more of various materials and may be formed by one or more of various methods other than lamination.

The front substrate 110 is positioned on the first sealing agent 131 to allow light (such as solar light) to pass, and may be a tempered glass for the purpose of protection of the solar cells 150 from external shock. The front substrate 110, in order to reduce or prevent solar light from being reflected and to increase transmission of the solar light, may be a low iron tempered glass containing a low iron content.

The back sheet 200 is a layer for protecting the other sides (the non-light-receiving surfaces) of the solar cells 150, and for performing water-proofing, insulation, and blocking of ultraviolet rays. The back sheet 200 may have a TPT(Tedlar/PET/Tedlar) type configuration; however, the embodiments of the invention are not limited thereto. Also, the back sheet 200 may include a material having high reflectance in order to reflect solar light entering the front substrate 110 to be used again. However, the embodiments of the invention are not limited thereto. Thus, the back sheet 200 may include a transparent material to allow the solar light to pass in order to achieve a bi-facial solar cell module. In embodiments of the invention, the solar cell module 100 may be the bi-facial solar cell module.

A structure of one solar cell 150 of the plurality of solar cells 150 will be described in more detail with reference to FIG.2 and FIG. 3. Then, the electric connection structure between the plurality of solar cells 150 will be described in more detail with reference to FIG. 4.

FIG. 2 is a partial cross-sectional view of one solar cell of the solar cell module shown in FIG. 1, and FIG. 3 is a rear plan view of the solar cell shown in FIG. 2.

Referring to FIG. 2, each of the solar cells 150 according to the embodiment includes a semiconductor substrate 10, a first conductive region 22 and a second conductive region 24 formed at one surface (hereinafter, referred to as a "back surface") to be apart from each other in a plan view, a first electrode 42 electrically connected to the first conductive region 22, and a second electrode 44 electrically connected to the second conductive region 24. Also, the solar cell 150 may include a passivation layer 32 for passivating the first and second conductive regions 22 and 24. This will be described in detail.

The semiconductor substrate 10 may include one or more of various semiconductor materials. For example, the semiconductor substrate 10 includes silicon having a dopant of a first conductivity type. Single crystal silicon or polycrystalline silicon may be used for the silicon, and the first conductivity type may be an n-type. That is, the semiconductor substrate 10 may include single crystal silicon or polycrystalline silicon having a group V element, such as phosphorus (P), arsenic (As), bismuth (Bi), antimony (Sb), or the like. However, the embodiments of the invention are not limited thereto, and the semiconductor substrate 10 may be a p-type.

The front and/or back surfaces of the semiconductor substrate 10 may be a textured surface to have protruded and/or depressed portions of various shapes (such as a pyramid shape). Thus, the surface roughness is increased by the protruded and/or depressed portions, and reflectance of the incident sun light at the front surface of the semiconductor substrate 10 can be reduced by the texturing. Then, an amount of the light reaching the p-n junction between the semiconductor substrate 10 and the emitter layer 20 can increase, thereby reducing an optical loss of the solar cell 100.

In FIG. 2, it is exemplified that only the front surface of the semiconductor substrate 10 is textured. However, the embodiments of the invention are not limited thereto. Thus, the protruded and/or depressed portions may be formed on at least one of the front surface and the back surface, or there may be no protruded and/or depressed portions at the front and back surfaces.

In the embodiment of the invention, the first conductive region 22 of a p-type and the second conductive region 24 of an n-type, which have different conductive types, are formed at the back surface of the semiconductor substrate 10. The first conductive region 22 and the second conductive region 24 may be apart from each other while interposing an isolation region 36 in order to prevent a shunt. By the isolation region 36, the first conductive region 22 and the second conductive region 24 are apart from each other, for example, by several tens of micrometers to several hundreds of micrometers. Also, the first conductive region 22 and the second conductive region 24 may have the same thickness, or may have different thicknesses. The embodiments of invention are not limited to the above distance or thickness of the first and second conductive regions 22 and 24.

The first conductive region 22 may be formed by ion-implanting a p-type dopant, and the second conductive region 24 may be formed by ion-implanting an n-type dopant. For the p-type dopant, a group III element such as B, Ga, In, and the like may be used. For the n-type dopant, a group V element such as P, As, Sb, and the like may be used.

However, the embodiments of the invention are not limited thereto. Therefore, a layer including amorphous silicon having the p-type dopant and a layer including amorphous silicon having the n-type dopant may be formed at the back surface of the semiconductor substrate 10 in order to form the first and second conductive regions 22 and 24. Also, the first and second conductive regions 22 and 24 may be formed by one or more of various methods other than above methods.

The plan shape of the first and second conductive region 22 and 24 will be described with reference to FIG. 3. FIG. 3 is a rear plan view illustrating the first and second conductive regions 22 and 24, and the first and second electrodes 42 and 44 of the solar cell 150 according to the embodiment of the invention. For a clearer illustration, the passivation layer 32 is omitted in FIG. 3.

The first conductive region 22 includes a first stem portion 22a formed along a first edge (lower edge of FIG. 3) of the semiconductor substrate 10 and a plurality of first branch portions 22b extended from the first stem portion 22a toward a second edge (upper edge of FIG. 3) opposite to the first edge. Also, the second conductive region 24 includes a second stem portion 24a formed along the second edge of the semiconductor substrate 10 and a plurality of second branch portions 24b extended from the second stem portion 24a toward the first edge. Each of the plurality of second branch portions 24b are positioned between adjacent two first branch portions 22b among the plurality of first branch portions 22b. That is, the first branch portions 22b of the first conductive region 22 and the second branch portions 24b of the second conductive region 24 are alternately arranged. By this shape, an area of the p-n junction can be increased.

In this instance, the first conductive region 22 of the p-type may be larger than the second conductive region 24 of the n-type. For example, areas of the first and second conductive regions 22 and 24 may be adjusted by changing widths of the first and second stem portions 22a and 24a and/or the first and second branch portions 22b and 24b of the first and second conductive regions 22 and 24.

In the embodiment of the invention, carriers are collected only at the back surface of the semiconductor substrate 10, and a migration length of the carriers at the semiconductor substrate 10 in a plan direction is relatively long. In this instance, the holes have mobility lower than that of the electrodes. Considering this, the first conductive region 22 of the p-type is larger than the second conductive region 24 of the n-type. Since the mobility of the electrons to the mobility of the holes is about 3:1, the area of the first conductive region 22 is about 2 to 6 times the area of second conductive region 24. That is, the above area ratio is to optimize the design of the first and second conductive regions 22 and 24 with consideration for the mobility of the electrons and the mobility of the holes.

Referring to FIG. 2 again, the passivation layer 32 may be formed on the first and second conductive regions 22 and 24. The passivation layer 32 passivates defects at the back surface of the semiconductor substrate 10 (that is, surfaces of the first and second conductive regions 22 and 24), and eliminates recombination sites of minority carriers. Thus, an open circuit voltage (Voc) of the solar cell 150 can be increased.

In the embodiment of the invention, the passivation layer 32 corresponding to the first and second conductive regions 22 and 24 is a single layer using one material. However, the embodiments of the invention are not limited thereto. The passivation layer corresponding to the first conductive region 22 and the passivation layer corresponding to the second conductive region 24 may include different materials. The passivation layer 32 may include at least one material selected from a group consisting of silicon oxide, silicon nitride, silicon oxy nitride, aluminum oxide, hafnium oxide, zirconium oxide, MgF₂, ZnS, TiO₂ and CeO₂.

The first electrode 42 electrically connected to the first conductive region 22 and the second electrode 44 electrically connected to the second conductive region 24 are formed on the passivation layer 32. More specifically, the first electrode 42 may be electrically connected to the first conductive region 22 by a first penetration hole 32a formed through the passivation layer 32, and the second electrode 44 may be electrically connected to the second conductive region 24 by a second penetration hole 34a formed through the passivation layer 32.

In this instance, as shown in FIG. 3, the first electrode 42 includes a stem portion 42a corresponding to the first stem portion 22a of the first conductive region 22 and branch portions 42b corresponding to the first branch portions 22b of the first conductive region 22. Similarly, the second electrode 44 includes a stem portion 44a corresponding to the second stem portion 24a of the second conductive region 24 and branch portions 44b corresponding to the second branch portions 24b of the second conductive region 24. The first electrode 42 (more specifically, the stem portion 42a of the first electrode 42) is disposed at one side (a lower side of FIG. 3) of the semiconductor substrate 10, and the second electrode 44 (more specifically, the stem portion 44a of the second electrode 44) is disposed at the other side (an upper side of FIG. 3) of the semiconductor substrate 10. However, the embodiments of the invention are not limited thereto. The first electrode 42 and the second electrode 44 may have various shapes in a plan view.

Referring to FIG. 2 again, the first and second electrodes 42 and 44 may include one or more of various materials. For example, each of the first and second electrodes 42 and 44 may include a plurality of metal layers in order to enhance various properties. Because the stacked structures of the first and second electrodes 42 and 44 are substantially same, only the first electrode 42 is illustrated in FIG. 2. The following description regarding the stacked structure of the first electrode 42 can be applied to one or both of the first and second electrodes 42 and 44.

The first and second electrodes 42 and 44 include a first metal layer 422, a second metal layer 424, and a third metal layer 426 sequentially stacked on the first and second conductive regions 22 and 24, respectively.

In this instance, for example, the first metal layer 422 may be a seed layer. The first metal layer 422 may include a layer including aluminum (Al), a layer including titanium-tungsten alloy (TiW) or chrome (Cr), and a layer including copper (Cu). The layer including aluminum is in ohmic-contact with the first and second conductive regions 22 and 24 and acts as a reflector. The layer including titanium-tungsten alloy or chrome acts as a barrier for preventing diffusion. The layer including copper acts as a seed layer of a subsequent plating process. Selectively (or alternatively), the first metal layer 422 may include nickel(Ni).

The second metal layer 424 may be a layer formed by electro-less plating or electro plating copper.

The third metal layer 426 is a capping layer. The third metal layer 426 may be a single layer including tin (Sn) or a single layer including silver (Ag), or may have a stacked structure of a layer including tin and a layer including silver. In this instance, the first metal layer 422 may have a thickness of about 300 to 500nm, and the second metal layer 424 may have a thickness of about 10∼30µm. Also, the third metal layer 426 may have a thickness of about 5 to 10µm. However, the embodiments of the invention are not limited thereto. The thicknesses of the first to third layers 422, 424, and 426 may be changed.

Also, the embodiments of the invention are not limited to the above staked structure. Accordingly, the first and second electrodes 42 and 44 may include a single layer including one or more of various materials or may include a plurality of layers.

On the other hand, a front surface field layer 50 is formed at the front surface of the semiconductor substrate 10. The front surface field layer 50 is a region where a dopant is doped with a concentration high than that of the semiconductor substrate 10, and act similar to back surface field (BSF) layer. That is, the front surface field layer 50 reduces or prevents recombination of the electrons and holes separated by the incident sun light at the front surface of the semiconductor substrate 10.

Also, the anti-reflection layer 60 may be formed on the front surface field layer 50. The anti-reflection layer 60 reduces reflectance (or reflectivity) of sun light incident to the front surface of the semiconductor substrate 10. Also, the anti-reflection layer 60 passivates defects at a surface or a bulk of the front surface of the semiconductor substrate 10.

By reducing the reflectance of sun light incident to the front surface of the semiconductor substrate 10, an amount of the sun light reaching the p-n junction formed between the semiconductor substrate 10 and the first or second conductive region 22 or 24 can be increased. Therefore, a short circuit current (Isc) of the solar cell 150 can be increased. Also, by passivating the defects, recombination sites of minority carriers are reduced or eliminated, thereby increasing an open-circuit voltage of the solar cell 150. Accordingly, the open-circuit voltage and the short-circuit current of the solar cell 150 can be increased by the anti-reflection layer 60, and thus, the efficiency of the solar cell 150 can be enhanced.

The anti-reflection layer 60 may include one or more of various materials. For example, the anti-reflection layer 60 may have a single film structure or a multi-layer film structure including, for example, at least one material selected from a group consisting of silicon nitride, silicon nitride including hydrogen, silicon oxide, silicon oxy nitride, MgF₂, ZnS, TiO₂ and CeO₂. However, the embodiments of the invention are not limited thereto.

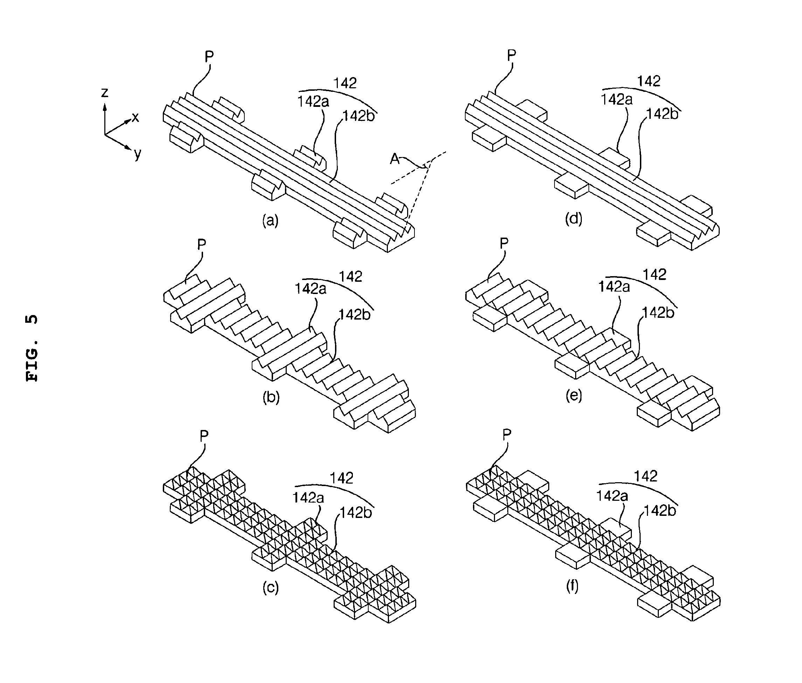

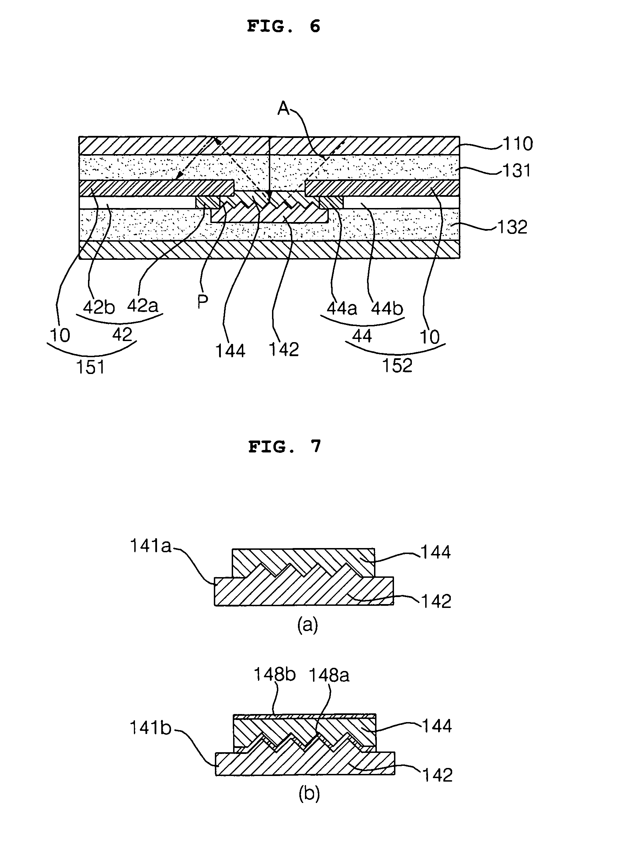

FIG. 4 is a rear plan view for illustrating a connection structure between two solar cells of the solar cell module shown in FIG. 1. FIG. 5 is a rear perspective view of ribbons according to various embodiments of the invention, and FIG. 6 is a partial cross-sectional view of the solar cell module shown in FIG. 4, taken along a line of VI-VI.

In the embodiment of the invention, a plurality of solar cells 150 are included. For clearer descriptions, the connection structure between a first solar cell 151 positioned at an upper portion and a second solar cell 152 positioned at a lower portion is exemplified in FIG. 4 and the following descriptions.

As shown in FIG. 4, the first electrode 42 of the first solar cell 151 (specifically, the stem portion 42a of the first electrode 42) and the second electrode 44 of the second solar cell 152 (specifically, the stem portion 44a of the second electrode 44) are adjacent to each other. The first electrode 42 of the first solar cell 151 and the second electrode 44 of the second solar cell 152 are electrically connected to each other by the ribbon 142.

That is, the ribbon 142 includes a connection portion 142a for connecting and being in contact with the first electrode 42 of the first solar cell 151 and the second electrode 44 of the second solar cell 152. In this instance, a plurality of connection portions 142a may be included, and the plurality of connection portions 142a are symmetric with respect to a center-line C along a longitudinal direction of the solar cell string 140. That is, the plurality of connection portions 142a are apart from each other with uniform distances on the first electrode 42 and the second electrode 44. Accordingly, stress (that is, thermal stress) generated by adhesion of the ribbon 142 and the first and second electrodes 42 and 44 can be minimized.

For example, the connection portion 142a of the ribbon 142 may have a thickness of about 0.05mm to 0.5mm, a width of about 5 to 30mm, and a length of about 5mm to 30mm. In the above range, the loss due to the electric resistance between the solar cells 150 can be minimized. However, the embodiments of the invention are not limited thereto. Thus, the thickness, the width, and the length of the ribbon 142 may be changed according to the size, the kind or the type, and the designs of the solar cells 150.

The ribbon 142 of the embodiment of the invention include a link portion 142b connected to the connection portions 142, along with the plurality of connection portions 142. Since the link portion 142b connects the plurality of connection portions 142a, a problem of inconvenience generated when the plurality of connection portions 142a are separately handled can be solved. Also, the link portion 142b is arranged on the insulating member 144, and unwanted short-circuit of the solar cell 150 is prevented.

The ribbon 142 may be one or more of various materials having high electrical properties and high physical properties. For example, the ribbon 142 may include a solder material, such as, a Sn/Ag/Cu-based material, a Sn/Ag/Pb-based material, a Sn/Ag-based material, or a Sn/Pb-based material. Also, the ribbon 142 may include a material having high conductivity (for example, aluminum). Further, the ribbon 142 may be formed by stacking an oxidation barrier on a solder material. However, the embodiments of the invention are not limited thereto.

The insulating member 144 is positioned between the ribbon 142 and the solar cell 150 for preventing a short-circuit between the ribbon 142 and the solar cell 150. The insulating member 144 is positioned between the semiconductor substrate 10 and the ribbon 142, and fills at least a space between the first electrode 42 of the first solar cell 151 and the second electrode 44 of the second solar cell 152. In this instance, considering an align tolerance, the insulating member 144 and the first and second electrodes 42 and 44 may be partially overlapped.

In the embodiment of the invention, the insulating member 144 is transparent. Thus, light can pass through the insulating member 144 and can proceed towards the ribbon 142. The light proceeding towards the ribbon 142 is reflected by the ribbon 142, and then, is reflected again at the front substrate 110. Thus, the light can be used for the photoelectric conversion of the solar cells 150. This will be described later with reference to FIGS. 5 and 6.

For example, the insulating member 144 may have a transmittancy (or transmittance) of about 50% to about 100%. In this instance, the transmittancy can be increased to 100% in order to maximize the reflectance and the efficiency, or the transmittancy can be decreased to 50% in order to consider aesthetic property as well as the reflectance so that an outline of the ribbon 142 can be shown at the front surface of the solar cell module 100.

The insulating member 144 may include one or more of various materials being transparent and having high insulating property. For example, the insulating member 144 may include a resin material such as polyethyleneterephthalate (PET), ethylene vinyl acetate (EVA), or silicon resin, or a ceramic material such as silicon oxide, or silicon nitride. When the transmittancy is decreased to 50% or less, a white pigment such as zinc oxide, titanium oxide, or silver white may be added to the insulating member 144 so that the insulating member 144 can have the desired transmittancy. However, the embodiments of the invention are not limited thereto. The insulating member 144 may include one or more of various materials other than the above materials, and the method for controlling the transmittancy may be changed.

The fixing method or structure of the ribbon 142, the insulating member 144, and the solar cell 150 will be described later in more detail.

Referring to FIG. 5, in the embodiment of the invention, at least one protrusion and depression (irregularity or unevenness) P is formed at a surface of the ribbon 142 adjacent to the solar cells 150. For example, the at least one protrusion and depression P has an inclined surface having an angle A of about 20 degrees to about 45 degrees to the front surface of the solar cells 150. In the above angle A, the light reflected at the inclined surface of the at least one protrusion and depression P can be total-reflected at an interface surface between the front substrate 110 and the outside air. The total-reflection will be described later in more detail. The at least one protrusion and depression P of the ribbon 142 has one or more of various shapes having the inclined surface.

For example, as shown in (a) of FIG. 5, the at least one protrusion and depression P is formed at the link portion 142b and the connection portion 142a, and has a stripe shape that extends in the longitudinal direction of the ribbon 142. That is, the at least one protrusion and depression P is a triangular prism having both sides of inclined surfaces and the triangular prism extends in the longitudinal direction of the ribbon 142. Selectively (or alternatively), as shown in (b) of FIG. 5, the at least one protrusion and depression P is formed at the link portion 142b and the connection portion 142a, and has a stripe shape that extends in the width direction of the ribbon 142. That is, the at least one protrusion and depression P is a triangular prism having both sides of inclined surfaces, and the triangular prism extends in the width direction of the ribbon 142. Selectively (or alternatively), as shown in (c) of FIG. 5, the at least one protrusion and depression P has a pyramid shape.

In (a) to (c) of FIG. 5, both of the link portion 142b and the connection portion 142a include the at least one protrusion and depression P. However, the embodiments of the invention are not limited thereto. Accordingly, as shown in (d) to (f) of FIG. 5, only the link portion 142a positioned between the first solar cell 151 and the second solar cell 152 may include the at least one protrusion and depression P.

As in the above, the insulating member 144 is transparent and the ribbon 142 includes the at least one protrusion and depression P to have the inclined surface having a predetermined angle with the front substrate 110. Then, as shown in an arrow of a solid line in FIG. 6, the light incident to the portion where the ribbon 142 is formed passes through the insulating member 144 and reaches the at least one protrusion and depression P of the ribbon 142. The light reaching the at least one protrusion and depression P of the ribbon 142 is reflected by the inclined surface of the at least one protrusion and depression P and proceeds towards the front substrate 110 (an arrow of a dotted line in FIG. 6). When the light has an angle larger than a critical angle, the light is total-reflected at the interface surface between the front substrate 110 and the outside air due to a difference in a refractive index, and the total-reflected light proceeds toward the solar cell 150 (arrow of an alternated long and short dash line in FIG. 6). Thus, the light is used in the solar cell 150.

That is, according to the embodiment of the invention, the insulating member 144 is transparent and the ribbon 142 includes the at least one protrusion and depression P to have the inclined surface having a predetermined angle with the front substrate 110. Therefore, the light incident to the portion where the ribbon 142 is formed can be used in the solar cells 150 by the reflection. Also, at a portion of the insulating member 144 where the ribbon 142 is not formed, the light can proceed towards the second sealing agent 132 and the back sheet 200. Then, the light is reflected at the second sealing agent 132 or the back sheet 200, and proceeds toward the solar cells 150. This effect can be increased when the second sealing agent 132 or the back sheet 200 having a high light-scattering property is used. In the embodiment of the invention, the used light (or usable light) can be increased and the efficiency of the solar cell 150 can be improved.

Contrary to the embodiment of the invention, in a conventional art, an opaque insulating member was used only in consideration of the aesthetic property. In the conventional art, due to the opaque insulating member, the sun light incident to a portion where the opaque insulating member is positioned cannot be used. Thus, high efficiency cannot be expected.

In the solar cell module 100 according to the embodiment of the invention, an output increases by 2W (watt) based on 260W (watt) solar cell module. Since a general glass has a transmittancy (or transmittance) of about 91% and anti-reflection glass has the transmittancy (or transmittance) of about 94%, an effect of output increase can be more enhanced when the front substrate 110 is the anti-reflection glass.

Also, in the embodiment of the invention, the at least one protrusion and depression P is formed at a portion of the ribbon 142 adjacent to the solar cell 150. Thus, the contact area of the ribbon 142 and the insulating member 144 can be increased. Accordingly, the adhesion property of the ribbon 142 and the insulating member 144 can be enhanced.

Hereinafter, a fixing method or structure of the solar cell 150, the ribbon 142, and the insulating member 144 will be described in more detail.

In one embodiment, the ribbon 142 and the insulating member 144 are coupled to each other, and thus, they form a ribbon assembly 141a or 141b. For example, as shown in (a) of FIG. 7, the insulating member 144 may be directly formed on the ribbon 142 having the at least one protrusion and depression P to form the ribbon assembly 141a. That is, the insulating member 144 is formed directly on the ribbon 142 by deposition, printing, and so on. In another embodiment, as shown in (b) of FIG. 7, a first bonding layer 148a is positioned between the ribbon 142 and the insulating member 144, and the ribbon 142 and the insulating member 144 are integrally formed by the first bonding layer 148a. Also, a second bonding layer 148b is formed on the other surface of the insulating member 144. The second bonding layer 148b can easily fix the ribbon assembly 141b to the solar cell 150. For the first and second bonding layers 148a and 148b, various adhesive agents or adhesive films may be used. Also, the first and second bonding layers 148a and 148b and the insulating member 144 may form a single double-sided tape.

In this instance, the solar cell 150, the ribbon 142, and the insulating member 144 can be fixed by fixing the ribbon assembly 141a or 141b formed by combining the ribbon 142 and the insulating member 144 to the back surface of the solar cell 150.

In this instance, after the insulating member 144 is positioned on the solar cell 150, the connection portion 142a at one side of the ribbon 142 is positioned on the first electrode 42 of the first solar cell 151 and the connection portion 142b at the other side of the ribbon 142 is positioned on the second electrode 44 of the second solar cell 152. The ribbon 142 may be electrically connected to the first and second electrodes 42 and 44 by one or more of various methods. For example, an additional adhesive layer may be formed between the ribbon 142 and the first and second electrodes 42 and 44.

When the ribbon 142 includes a solder material, the additional adhesive layer may be a flux. That is, after the flux is applied on the first and second electrodes 42 and 44, and the ribbon 142 is positioned on the flux, the firing process is performed. Then, the ribbon 142 and the first and second electrodes 42 and 44 are connected.

Selectively (or alternatively), the ribbon 142 and the first and second electrodes 42 and 44 may be connected by a conductive film or tape used for the additional adhesive layer. For example, the conductive film is used between the first and second electrodes 42 and 44 and the ribbon 142. Or, after disposing the conductive tape between the first and second electrodes 42 and 44 and the ribbon 142, thermo-compression bonding may be performed. The conductive film includes conductive particles (including materials of high conductivity, such as gold, silver, nickel, or copper) dispersed in a film (including, for example, an epoxy resin, an acryl resin, a polyimide resin, or a polycarbonate resin). When the thermo-compression bonding is performed on the conductive film, the conductive particles are exposed to the outside, and the first and second electrodes 42 and 44 and the ribbon 142 are electrically connected by the exposed conductive particles. In the instance that the conductive tape or film is used, the process temperature can decrease and the bending of the solar cell string 140 can be prevented. In this instance, the conductive tape may be coated on the ribbon 142, and thus, the conductive tape and the ribbon 142 may be integrally formed.

Selectively (or alternatively), the ribbon 142 and the first and second electrodes 42 and 44 are connected by a conductive adhesive agent layer used for the additional adhesive layer. That is, after the conductive adhesive agent layer is applied to the first and second electrodes 42 and 44, the ribbon 142 is disposed on the first and second electrodes 42 and 44. Accordingly, the ribbon 142 and the first and second electrodes 42 and 44 are connected.

Selectively (or alternatively), by using a metal layer formed through firing a metal paste for the additional adhesive layer, the ribbon 142 and the first and second electrodes 42 and 44 may be connected. That is, the metal paste is applied on the first and second electrodes 42 and 44, the ribbon 142 is disposed on the metal paste, and the firing process is performed. Accordingly, the ribbon 142 and the first and second electrodes 42 and 44 are connected. In this instance, as the metal paste, a paste for a low-temperature firing (such as, a silver paste) may be used.

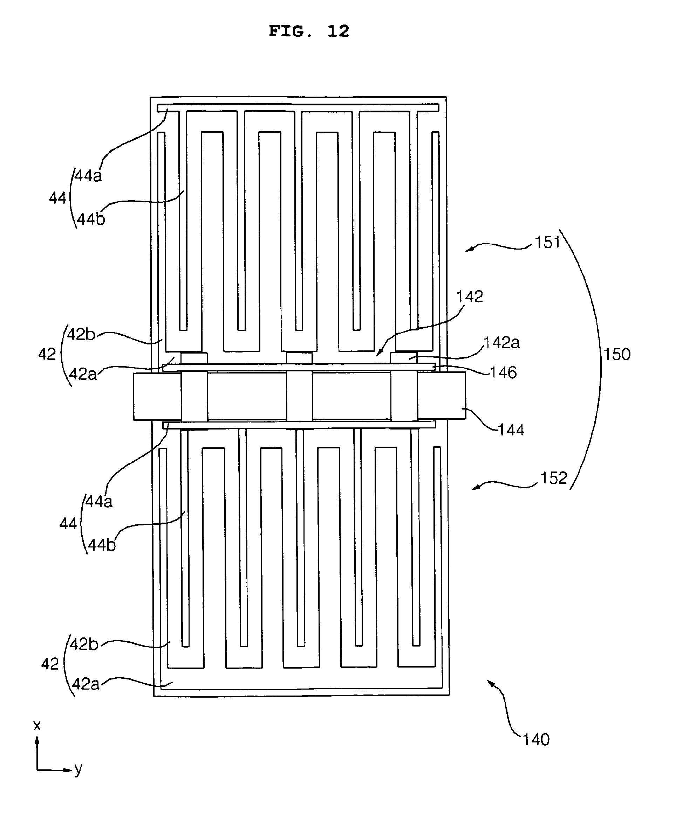

Selectively (or alternatively), by disposing a fixing portion (reference numeral 146 of FIG. 12) on the first and second electrodes 42 and 44 and the ribbon 142, the ribbon 142 and the first and second electrodes 42 and 44 may be connected. This will be described later with reference to FIG. 12.

In another embodiment, the ribbon 142 and the insulating member 144 are separately fixed on the solar cells 150. In this instance, the insulating member 144 having a sheet shape, a film shape, or a paste shape is positioned on the back surface of the solar cell 150, and the ribbon 142 is positioned on the insulating member 144 to be connected to the first and second electrodes 42 and 44 of the solar cell 150. Accordingly, the plurality of solar cells 150 are electrically connected. As in the above, the insulating member 144 and the solar cell 150 are fixed directly or through a bonding layer, and the ribbon 142 and the solar cell 150 are fixed directly or through an adhesive layer or a fixing portion. This is the same as in the above, and thus, detailed descriptions will be omitted.

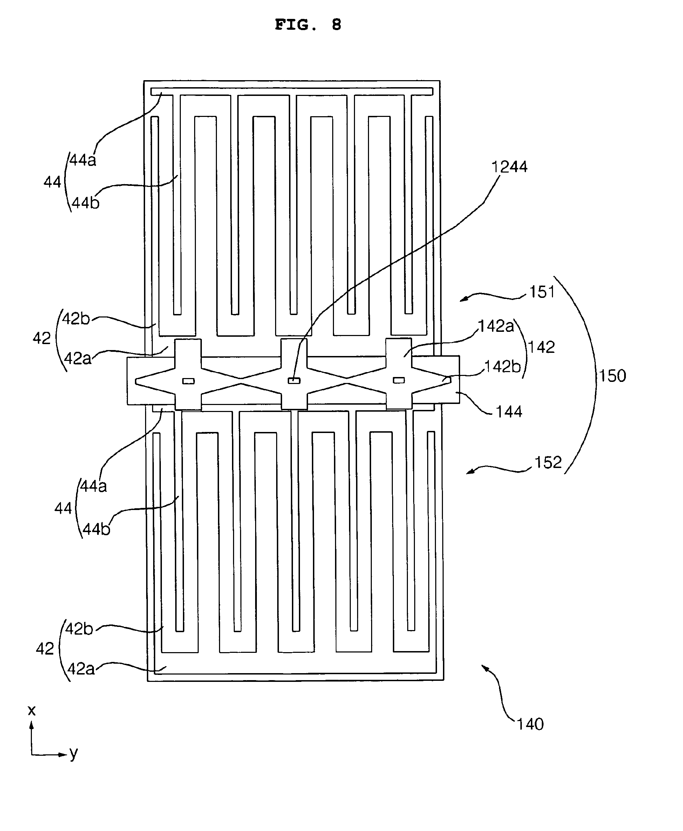

Hereinafter, other embodiments of the invention will be described in detail with reference to FIGS. 8 to 18. In the following description, any described portions already described above will be omitted, and any portions not already described above will be described in detail.

FIG. 8 is a rear plan view for illustrating a connection structure between two solar cells of a solar cell module according to another embodiment of the invention.

Referring to FIG. 8, a link portion 142b has portion where a width changes in the embodiment of the invention, unlike in the above embodiment including the link portion 142b having a uniform width. More specifically, a portion of the link portion 142b adjacent to a connection portion 142a has a width different from that of a portion of the link portion 142b away from the connection portion 142a. More specifically, the width of the link portion 142b gradually decreases as a distance from the connection portion 142a increases. Accordingly, the link portion 142b corresponding to one connection portion 142a has a general diamond shape or a diamond-like shape.

Also, in the embodiment of the invention, a penetration hole 1244 is formed at a portion of the connection portion 142a overlapped with the insulating member 144. That is, the ribbon 142 according to the embodiment includes the penetration hole 1244 at a portion having a first width (a relatively large width), and thus, the width difference of the ribbon 142 can be minimized. Accordingly, the thermal stress can be minimized, and thermal shock induced when the ribbon 142 is reduced or expanded by the heat can be minimized. Accordingly, durability of the ribbon 142 can be enhanced. Also, the adhesive property with the insulating member 144 can be enhanced by the penetration hole 1244.

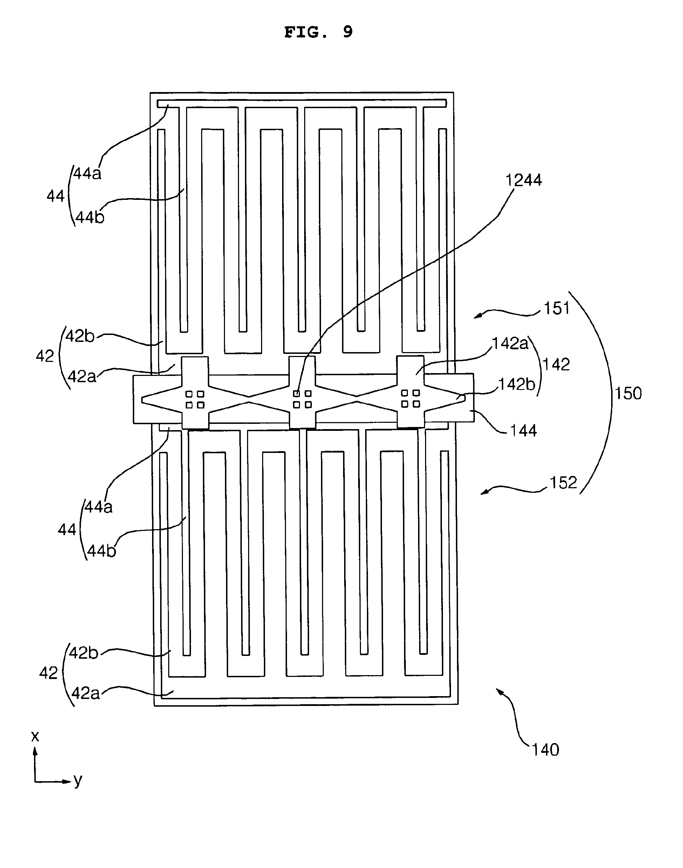

One penetration hole 1244 is formed at the portion of the connection portion 142a overlapped with the insulating member 144 in FIG. 8. However, the embodiments of the invention are not limited thereto, and various modifications are possible. That is, as shown in FIG. 9, a plurality of penetration holes 1244 are formed at each of the portion of the connection portion 142a overlapped with the insulating member 144. Accordingly, the thermal stress induced by the width difference can be minimized, and the adhesive property with the insulating member 144 can be enhanced.

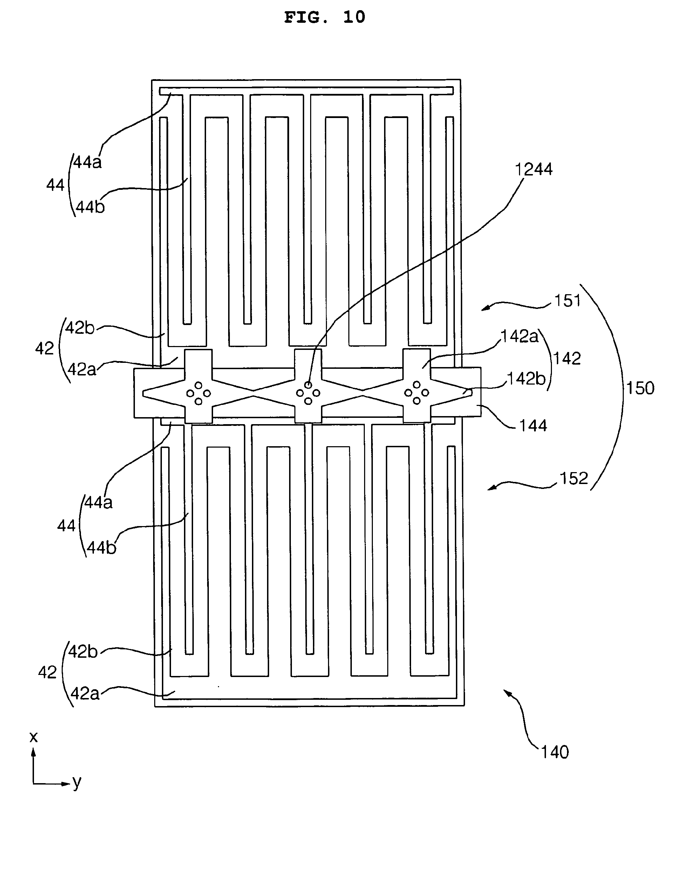

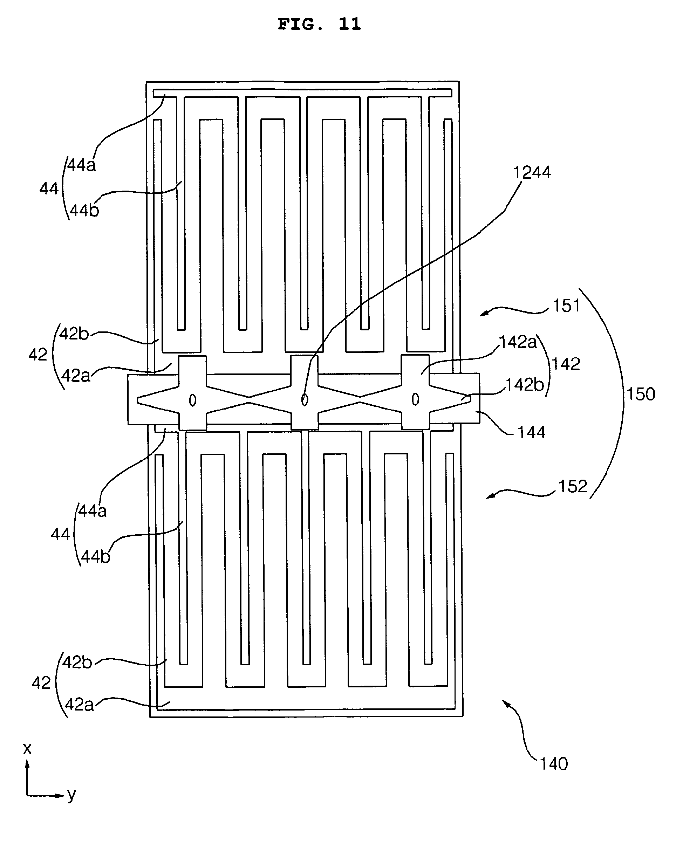

Also, the penetration hole 1244 is a quadrangle shape in FIG. 8. However, the embodiments of the invention are not limited thereto. Therefore, the penetration hole 1244 may have a circular shape as shown in FIG. 10, or the penetration hole 1244 have an oval shape as shown in FIG. 11. Also, the penetration hole 1244 may have one or more of various shapes such as a triangular shape, a diamond shape, and so on.

FIG. 12 is a rear plan view for illustrating a connection structure between two solar cells of a solar cell module according to yet another embodiment of the invention.

Referring to FIG. 12, in the embodiment of the invention, a ribbon 142 includes a plurality of connection portions 142a only, without the link portion (reference numeral 142b of FIG. 4). Then, by minimizing the thermal stress, the thermal shock induced when the ribbon 142 is reduced or expanded by the heat can be minimized. Accordingly, the durability of the ribbon 142 can be enhanced.

In FIG. 12, for example, a fixing portion 146 for fixing the ribbon 142 to the first and second electrodes 42 and 44 is formed on the connection portion 142a. The fixing portion 146 may be one of a film, a tape, a paste, and so on. The fixing portion 146 may include one or more of various materials that is able to fix the ribbon 142 to the first and second electrodes 42 and 44. In this instance, after the ribbon 142 is positioned on the first and second electrodes 42 and 44, the fixing portion 146 is positioned on the first and second electrodes 42 and 44 and the ribbon 142. Accordingly, the first and second electrodes 42 and 44 and the ribbon 142 are connected. Selectively (or alternatively), after the plurality of connection portion 142a and the fixing portion 146 are integrally formed, the connection portion 142a and the fixing portion 146 are simultaneously fixed to the back surface of the solar cell 150. However, the embodiments of the invention are not limited thereto, and the fixing portion 146 may not be used.

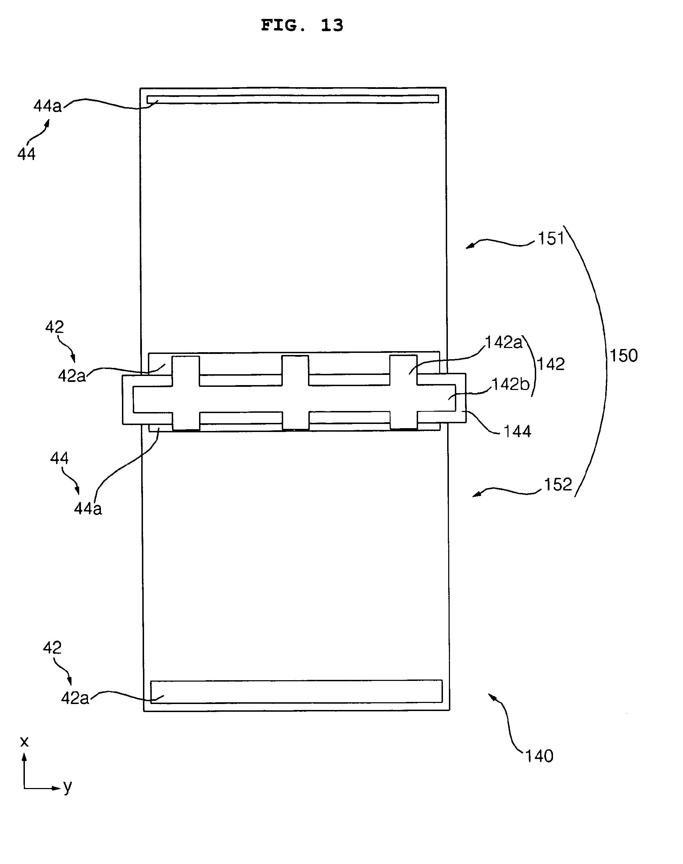

FIG. 13 is a rear plan view for illustrating a connection structure between two solar cells of a solar cell module according to yet another embodiment of the invention.

Referring to FIG. 13, in the embodiment of the invention, the first and second electrodes 42 and 44 include stem portions 42a and 44a, respectively, without the branch portions (reference numerals 42b and 44b of FIG. 3). Since the first and second electrodes 42 and 44 have a simple structure, the process time and the process cost can be reduced.

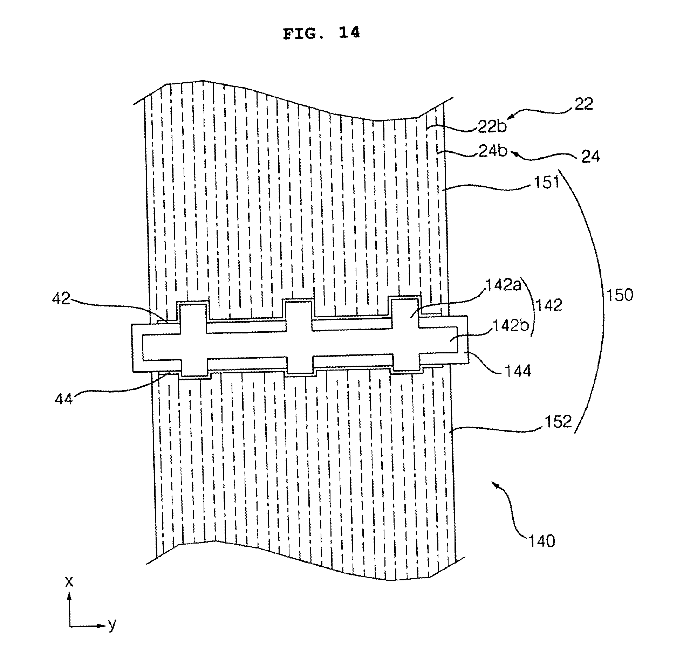

FIG. 14 is a rear partial plan view for schematically illustrating a connection structure between two solar cells of a solar cell module according to yet another embodiment of the invention. For clear descriptions, the first and second conductive regions 22 and 24 are schematically illustrated in FIG. 14.

Referring to FIG. 14, the first electrode 42 and the second electrode 44 according to the embodiment may have a small width at portions where the connection portions 142a are not formed, and may have a large width at portions where the connection portions 142a are formed. Accordingly, at the portion where the connection portion 142a is not formed, the first and the second electrodes 42 and 44 have small widths, and thus, the first and second branch portions 22b and 24b of the first and second conductive regions 22 and 24 can be extended.

More specifically, in the first electrode 42 positioned at one side (a lower side) of the semiconductor substrate 10, the portions where the connection portions 142a are not formed has the small width. Then, the second branch portions 24b can be extended at the portions where the connection portions 142a are not adjacent. Also, in the second electrode 44 positioned at the other side (an upper side) of the semiconductor substrate 10, the portions where the connection portions 142a are not formed has the small width. Then, the first branch portions 22b can be extended at the portions where the connection portions 142a are not adjacent.

Accordingly, the areas of the first and second conductive regions 22 and 24, which participate in the photoelectric conversion, can increase. As a result, the efficiency of the solar cell can be effectively enhanced.

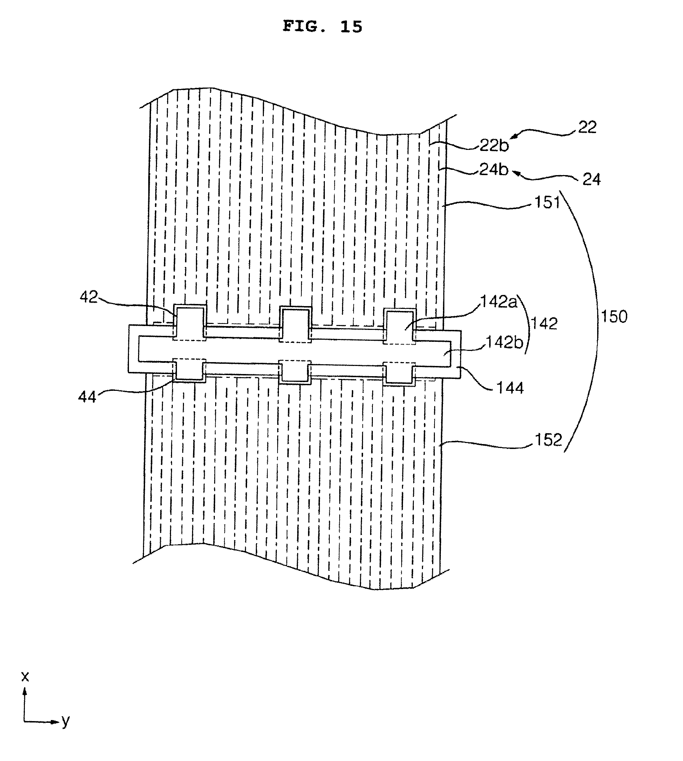

In FIG. 14, each of the first and second electrodes 42 and 44 is extended at one side of the semiconductor substrate 10, and has a large width at portions corresponding to the connection portion 142a of the ribbon 142 and has a small width at a portion connecting the portions corresponding to the connection portions 142a of the ribbon 142. However, the embodiments of the invention are not limited thereto. Therefore, as shown in FIG. 15, the first and second electrodes 42 and 44 may have island shapes that are formed only at portions corresponding to the connection portions 142a of the ribbon 142.

In addition, in FIG. 14 and FIG. 15, each of the first and second electrodes 42 and 44 includes only the stem portions (reference numerals 42a and 44a of FIG. 4) positioned on one side of the semiconductor substrate 10. However, the embodiments of the invention are not limited thereto. That is, the first and second electrodes 42 and 44 may further include branch portions (reference numerals 42b and 44b of FIG. 4) corresponding to branch portions 22b and 24b of the first and second conductive regions 22 and 24. In this instance, the stem portions 42a and 44a may have a small width at the portions where the connection portions 142a are not formed, and may have a large width at the portions where the connection portions 142a are formed. Also, at the portion where the connection portion 142a is not adjacent, the first and the second branch portions 22b and 24b of the first and second conductive regions 22 and 24 and the branch portions 42b and 44b and the first and second electrodes 42 and 44 can be extended.

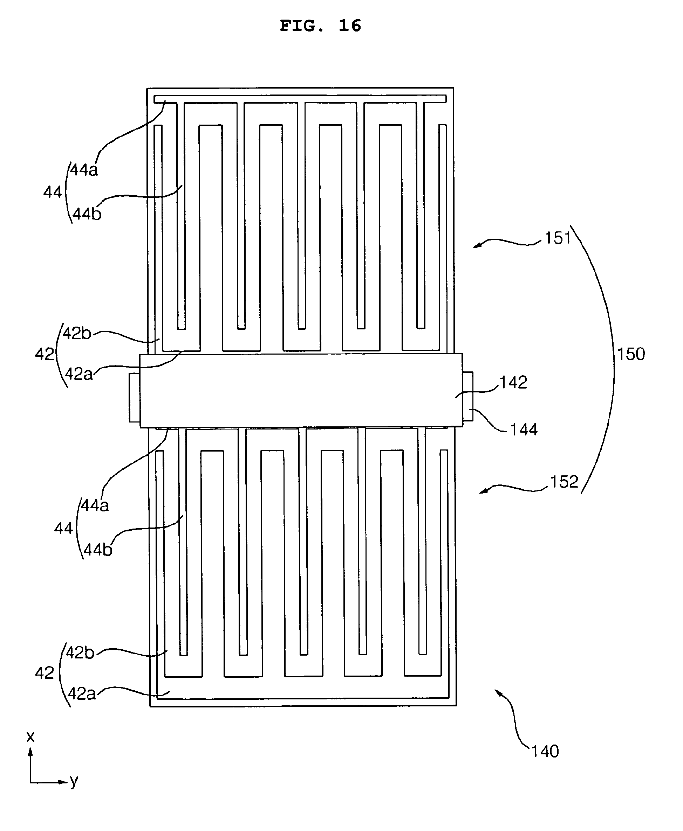

FIG. 16 is a rear partial plan view for illustrating a connection structure between two solar cells of a solar cell module according to yet another embodiment of the invention.

Referring to FIG. 16, a ribbon 142 according to the embodiment has a uniform width. That is, an edge of the ribbon 142 (an upper edge of FIG. 16) is entirely in contact with the first electrode 42 of the first solar cell 151, and the other edge of the ribbon 142 (a lower edge of FIG. 16) is entirely in contact with the second electrode 44 of the second solar cell 152. Accordingly, the contact area of the ribbon 142 and the first and second electrodes 42 and 44 can increase, and the electrons or the holes can be effectively collected.

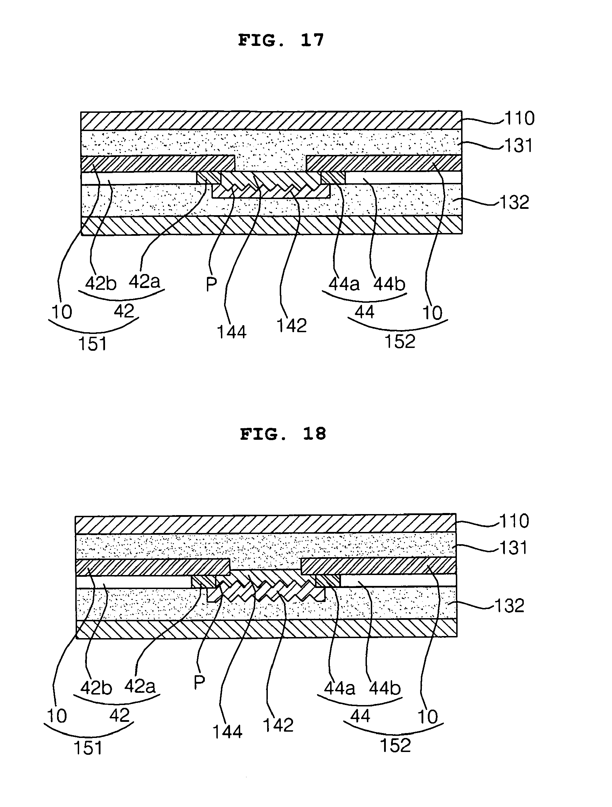

FIG. 17 is a cross-sectional view of a solar cell module according to another embodiment of the invention. Referring to FIG. 17, an insulating member 144 according to the embodiment is positioned between a semiconductor substrate 10 of first and second solar cells 151 and 152 and a ribbon 142, and between a first electrode 42 of the first solar cell 151 and a second electrode 44 of the second solar cell 152. Thus, the insulating member 144 is not positioned on side surfaces of semiconductor substrates 10 of the first and second solar cells 151 and 152. Unlike this, the insulating member 144 is positioned between the first and second solar cells 151 and 152 (specifically, between the side surfaces of the semiconductor substrates 10).

FIG. 18 is a cross-sectional view of a solar cell module according to still another embodiment of the invention. Referring to FIG. 18, in the embodiment of the invention, at least one protrusion and depression P having an inclined surface is formed on the surface of a ribbon 142 adjacent to the first and the second solar cells 151 and 152 and on the opposite surface of the ribbon 142 facing the back sheet 200. That is, the at least one protrusion and depression P is formed at both sides of the ribbon 142, and thus, the light incident to the back surface of the solar cell module can be reflected and can be reused. This is useful to a bi-facial solar cell module.

In the solar cell module according to embodiments, the surface of the ribbon adjacent to a surface of the solar cell includes at least one protrusion and depression, and an insulating member positioned between the ribbon and the solar cells is transparent. The light passing through the insulating member is reflected to the at least one protrusion and depression, and is total-reflected at the front substrate, and thus, the light can be used. Accordingly, the reflected light can increase and the efficiency of the solar cell module can be enhanced. In this instance, the transmittancy can be reduced to a degree larger than a predetermined value considering the aesthetic property, and then, the transmittancy can be maintained and the aesthetic property can be enhanced.

Certain embodiments of the invention have been described. However, the embodiments of the invention are not limited to the specific embodiments described above; and various modifications of the embodiments are possible by those skilled in the art to which the invention belongs without leaving the scope defined by the appended claims.

## Claims

1. A solar cell module, comprising:
a plurality of solar cells comprising a first solar cell and a second solar cell;
a ribbon electrically connecting the first solar cell and the second solar cell; and
an insulating member positioned between the plurality of solar cells and the ribbon,
wherein the insulating member is transparent.

2. The solar cell module according to claim 1, wherein the insulating member has a transmittance of about 50% to about 100%.

3. The solar cell module according to claim 1, wherein each of the first solar cell and the second solar cell comprises:
a semiconductor substrate;
a first conductive region and a second conductive region formed at the semiconductor substrate;
a first electrode positioned at a back surface of the semiconductor substrate, wherein the first electrode is electrically connected to the first conductive region; and
a second electrode positioned at the back surface of the semiconductor substrate while being apart from the first electrode, wherein the second electrode is electrically connected to the second conductive region, and
wherein the ribbon comprises at least one protrusion and depression having an inclined surface on at least one surface of the ribbon.

4. The solar cell module according to claim 3, wherein the at least one protrusion and depression is formed at both surfaces of the ribbon, or is formed at a surface of the ribbon adjacent to the plurality of solar cells.

5. The solar cell module according to claim 3, wherein the at least one protrusion and depression extend along a longitudinal direction or a width direction of the ribbon-, or
wherein the at least one protrusion and depression has a pyramid shape.

6. The solar cell module according to claim 3, wherein the inclined surface of the at least one protrusion and depression has an angle of about 20 degrees to about 45 degrees to a front surface of the solar cell module.

7. The solar cell module according to claim 1, wherein the ribbon comprises a connection portion for connecting the first electrode of the first solar cell and the second electrode of the second solar cell.

8. The solar cell module according to claim 1, wherein at least a part of the first conductive region and the second conductive region is positioned at the back surface of the semiconductor substrate,
wherein the first electrode is positioned at a first side of the semiconductor substrate,
wherein the second electrode is positioned at a second side of the semiconductor substrate opposite to the first side,
wherein the first conductive region comprises a plurality of branch portions extending from the first electrode toward the second electrode,
wherein the second conductive region comprises a plurality of branch portions extending from the second electrode toward the first electrode,
wherein the plurality of branch portions of at least one of the first conductive region and the second conductive region have first portions adjacent to the connection portion and second portions other than the first potions, and
wherein the second portions are longer than the first portions.

9. The solar cell module according to claim 7, wherein the connection portion comprises a plurality of portions, and
wherein the plurality of portions are symmetric with respect to a center-line of the solar cell module.

10. The solar cell module according to claim 9, wherein the plurality of portions are apart from each other.

11. The solar cell module according to claim 7, further comprising a link portion connected to the connection portion and corresponding to the insulating member.

12. The solar cell module according to claim 11, wherein a width of the link portion gradually decreases as a distance from the connection portion increases.

13. The solar cell module according to claim 1, wherein the ribbon comprises a portion having a first width and a portion having a second width, and the portion having the first width includes at least one penetration hole.

14. The solar cell module according to claim 1, wherein the ribbon has a uniform width over the entire ribbon.

15. The solar cell module according to claim 1, further comprising a fixing portion on the ribbon,
wherein the fixing portion fixes the ribbon to the first electrode or the second electrode.
